# EUROPEAN PATENT APPLICATION

(11) **EP 4 459 818 A2**
(43) Date of publication of application: **06.11.2024**
(21) Application number: 24173824.4
(22) Date of filing: 02.05.2024
(51) Int. Cl.: H02H 3/02, H02H 3/14

(54) **MARINE PROTECTION CIRCUIT**

(30) Priority: 03.05.2023 SE 2350534
(71) Applicant: Volvo Penta Corporation, 405 08 Göteborg (SE)
(72) Inventor: LANNETOFT, Simon, 461 94 Trollhättan (SE)
(74) Representative: Zacco Sweden AB

(57) **Abstract**

A marine protection (130) circuit comprising a first terminal (131) connectable to a ground connection (120) of a marine vessel (100) or a waterborne object and a second terminal (132) connectable to a ground connection (160) of an on-shore power supply (170). The marine protection circuit (130) is configured to engage when a voltage across the first and the second terminals (131, 132) is above a threshold value. The marine protection circuit (130) is configured to present low resistance between the first and the second terminals (131, 132) when engaged. The marine protection (130) is configured to present high resistance between the first and the second terminals (131, 132) when unengaged.

## Description

### TECHNICAL FIELD

The disclosure relates generally marine electrical safety protection equipment. In particular, the disclosure relates to a marine protection circuit connectable to a ground connection of a marine vessel or a waterborne object and to a ground connection of an on-shore power supply. The disclosure can be applied in marine vessels, such as boats, ships, and other watercrafts, or in waterborne objects such as floating docks, jetties, or rafts, e.g., with a charger for marine vessels. Although the disclosure may be described with respect to a particular marine vessel, the disclosure is not restricted to any particular marine vessel or waterborne object.

### BACKGROUND

When a marine vessel, such as a ship, is docked at a port, the marine vessel is commonly connected to an on-shore power supply. The on-shore power supply can e.g. be used for charging internal batteries of the marine vessel and/or be used to bypass internal batteries to provide electricity to the marine vessel. When connected to the on-shore power supply, the marine vessel ground (e.g. the ground of a ship hull) and the shore ground (ground of the on-shore power supply) are normally connected in an equipotential manner.

The marine vessel and/or the on-shore power supply are typically provided with an electrical safety device. The electrical safety device is triggered when a current is leaked from the on-shore power supply to the ground connection. When triggered, the electrical safety device quickly breaks the ground connection, and thereby protects the marine vessel and the on-shore power supply. The electrical safety device may be a residual-current device (RCD) or a fuse.

A problem with the ground connection is that there may be galvanic currents (also called corrosion currents) between the marine vessel and any other object connected to the same ground potential, such as other marine vessels or other metal structures in the area. The galvanic currents may corrode any metal that is inferior in an electrochemical series. Such corrosion may destroy the drivetrain, valves, or other components.

A common solution is to install a galvanic isolator, such as a so-called zinc saver, between the marine vessel ground and the shore ground. Galvanic isolation means that a direct conduction path is isolated, while information or energy is allowed to flow by other means, such as through inductive or capacitive means. A galvanic isolator can thus maintain a ground connection between the marine vessel and the shore for safety purposes, while also preventing any stray currents coming up the ground line and damaging the marine vessel.

One type of galvanic isolator used for the mentioned marine vessel application comprises diodes. A problem with such solution, however, is that they only isolate dc (direct current) voltages up a relatively low magnitude, such as 1.4 Volt. For example, if there are two boats and they are connected to shore via protective earth, and the hulls of the two boats are of different materials, then will there be a voltage across the two hulls about 1 Volt, where the water will be like the electrolyte. The effective circuit between the two hulls, the protective earth, and the water will effectively form a battery. If the relatively low magnitude of 1.4 Volt is surpassed, the diodes starts to conduct dc current and the corrosion protective properties are lost. Another type of galvanic isolator used for the mentioned marine vessel application comprises a transformer. A problem with such solution, however, is that transformers are heavy, large, and expensive.

Galvanic isolators are not only needed for marine vessels, they are also needed for any waterborne object power is supplied to. Examples of such waterborne objects are floating docks, jetties, or rafts with a charger for marine vessels.

Thus, there is a continuous need for improved means for preventing corrosion currents and providing safety for marine vessels and for waterborne objects.

### SUMMARY

It is an object of the present disclosure to provide improved means for preventing corrosion currents and providing safety. This object is at least in part achieved by a marine protection circuit comprising a first terminal connectable to a ground connection of a marine vessel or a waterborne object and a second terminal connectable to a ground connection of an on-shore power supply. The marine protection circuit is configured to engage when a voltage across the first and the second terminals is above a selectively set threshold value. The marine protection circuit is configured to present low resistance between the first and the second terminals when engaged. The marine protection circuit is configured to present high resistance between the first and the second terminals when unengaged.

The disclosed marine protection circuit can isolate dc voltages larger than diode-based galvanic isolators by selectively setting a threshold value of the voltage across the first and second terminals. A galvanic isolator comprising diodes has a set voltage value. The disclosed marine protection circuit is also lightweight, compact, and inexpensive.

The high resistance isolates the first and the second terminals from each other, or at least reduce any current flowing between these terminals. Thus, protection from corrosion currents is provided. The low resistance enables an electrical safety system to function properly. For example, when there is a leakage current to ground, the low-resistance path between the first and the second terminals enables an electrical safety device to quickly break an electrical circuit comprising the path with the leakage current to ground. Such electrical safety device may be a residual-current device (RCD) or a fuse. Consequently, the disclosed marine protection circuit maintains electrical safety.

The disclosed marine protection circuit also presents a low-resistance path between the first and the second terminals for dc when engaged. Consequently, any static charge built up on the marine ground or waterborne object ground can safely be discharged.

According to some aspects, the marine protection circuit is configured to present a short circuit between the first and the second terminals when engaged. This way, the marine protection circuit may trigger safety functions quickly and reliably. In practice, a short circuit may mean a resistance less than 1 Ohm.

According to some aspects, the marine protection circuit is configured to present an open circuit between the first and the second terminals when unengaged. This way, the marine protection circuit provides high isolation between the first and the second terminals when unengaged. In practice, an open circuit may mean a resistance larger than 1 Megaohm. Alternatively, an open circuit may bean a resistance large enough that the corrosion current is negligible.

According to some aspects, the marine protection circuit comprises a crowbar circuit connected between the first and the second terminals. A crowbar circuit is particularly lightweight, compact, and inexpensive.

The crowbar circuit may be an active crowbar circuit. An active crowbar can remove the short circuit, i.e., be unengaged after it has been engaged. This allows the protection circuit to resume normal operation after it has been triggered.

According to some aspects, the selectively set threshold value is larger than 20 Volt. According to additional aspects, the selectively set threshold value is within 20 to 60 Volt. Other values are also possible. A galvanic isolator comprising diodes only isolate dc voltages up to 1.4 Volt.

There is also disclosed herein an on-shore power supply for providing power to a marine vessel or a waterborne object. The on-shore power supply comprises the marine protection circuit according to the discussions above. The on-shore power supply is associated with the above-discussed advantages.

There is also disclosed herein a marine vessel or a waterborne object comprising the marine protection circuit according to the discussions above. The marine vessel or waterborne object is associated with the above-discussed advantages.

There is also disclosed herein a marine power connector for a marine vessel or a waterborne object. The marine power connector comprises the marine protection circuit according to the discussions above. The marine power connector is arranged to connect to an on-shore power supply. The marine power connector is associated with the above-discussed advantages. The marine power connector may be adapted to conduct one-phase power or three-phase power.

There is also disclosed herein an on-shore power connector for an on-shore power supply. The on-shore power connector comprises the marine protection circuit according to the discussions above. The on-shore power connector is arranged to connect to a marine vessel or a waterborne object. The on-shore power connector is associated with the above-discussed advantages. The on-shore power connector may be adapted to conduct one-phase power or three-phase power.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated. Further features of, and advantages with, the present disclosure will become apparent when studying the appended claims and the following description. The skilled person realizes that different features of the present disclosure may be combined to create embodiments other than those described in the following, without departing from the scope of the present disclosure.

### BRIEF DESCRIPTION OF THE DRAWINGS

With reference to the appended drawings, below follows a more detailed description of embodiments of the present disclosure cited as examples. In the drawings:
Figure 1 shows a marine vessel connected to an on-shore power supply;
Figure 2 shows a circuit of a marine vessel connected to an on-shore power supply; and
Figure 3 shows a marine protection circuit.

### DETAILED DESCRIPTION

The present disclosure is described more fully below with reference to the accompanying drawings, in which certain aspects of the present disclosure are shown. The present disclosure may, however, be embodied in many different forms and should not be construed as limited to the embodiments and aspects set forth herein; rather, these embodiments are provided by way of example so that this disclosure will be thorough and complete, and will fully convey the scope of the present disclosure to those skilled in the art. Like numbers refer to like elements throughout the description.

It is to be understood that the present disclosure is not limited to the embodiments described herein and illustrated in the drawings; rather, the skilled person will recognize that many changes and modifications may be made within the scope of the appended claims.

There is disclosed herein a marine protection circuit for a marine vessel or a waterborne object. The disclosed marine protection circuit can be used in any type of marine vessels, such as boats, ships, and other watercrafts, or in waterborne objects such as a floating dock, jetty, or raft, e.g., with a charger for marine vessels.

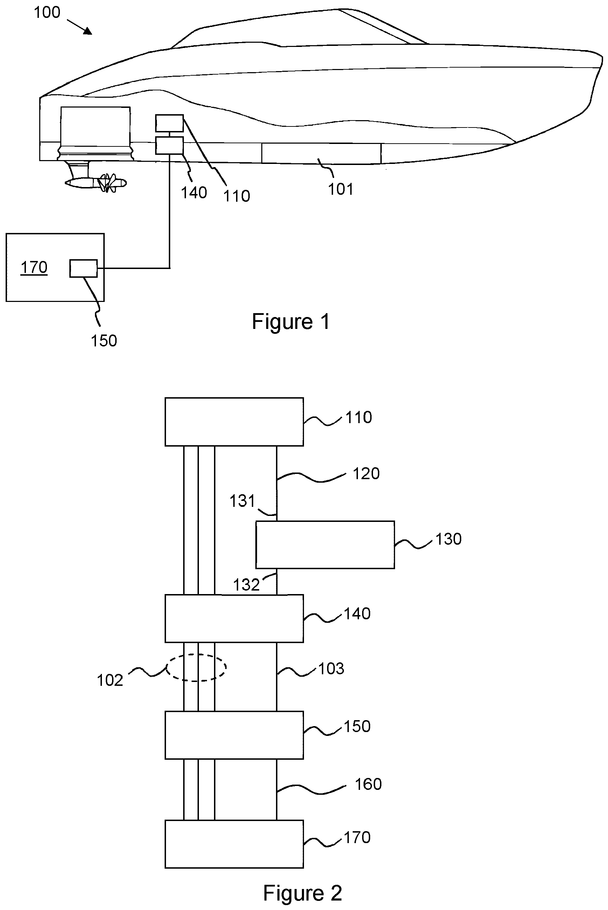

Figure 1 shows a schematic illustration of marine vessel 100. The marine vessel 100 is provided with a battery 101. The marine vessel 100 is connected to an on-shore power supply 170. The on-shore power supply comprises an on-shore power connector 150, which is connected to the marine vessel via a marine power connector 140. In some cases, there is no on-shore power connector 150 comprised in the on-shore power supply; a cable is instead integrated in the on-shore power supply 170. The termination of the marine power connector 140 is represented by a marine vessel load 110. Normally, the marine power connector 140 is arranged on the marine vessel 100 and the on-shore power connector 150 is arranged on the on-shore power supply 170. In that case, the marine power connector 140 and the on-shore power connector 150 are connected via a cable. However, the marine power connector 140 may be connected to the marine vessel load 110 via a cable, and/or the on-shore power connector 150 may be connected to the on-shore power supply 170 via a cable.

The on-shore power supply can e.g. be used for charging internal batteries 101 of the marine vessel 100 and/or be used to bypass internal batteries to provide electricity to the marine vessel. Alternatively, or in combination of, the on-shore power supply can be used for supplying power to a waterborne object, such as a raft. In that case, the raft may comprise a charging station for marine vessels.

The marine vessel load 110 may represent charging the internal batteries and/or any general consumption of electricity. In any case, the on-shore power supply may be configured to provide, e.g., one-phase power or three-phase power to the marine vessel or the waterborne object. In that case, the marine power connector 140 may be adapted to conduct one-phase power or three-phase power. Similarly, the on-shore power connector 150 may be adapted to conduct one-phase power or three-phase power.

As mentioned, there is a need for improved means for preventing corrosion currents and providing safety when the marine vessel or waterborne object is connected to the on-shore power supply.

Figure 2 shows an example of a circuit corresponding to the connections in Figure 1 provided with the disclosed marine protection circuit 130. Note that the marine protection circuit 130 does not need to be installed between 110 and 140 as is shown in Figure 2; the protection circuit 130 may, e.g., be arranged anywhere between protective earth on the marine vessel and protective earth on shore. The marine protection circuit 130 comprises a first terminal 131 connectable to a ground connection 120 of a marine vessel 100 or a waterborne object and a second terminal 132 connectable to a ground connection 160 of an on-shore power supply 170. The marine protection circuit 130 is an electronic circuit adapted to provide protection from corrosion currents while maintaining electrical safety.

In the example of Figure 2, the marine vessel load is provided with a ground connection 120, which may also be called marine vessel protective earth, which is connected to the first terminal 131 of the marine protection circuit 130. Furthermore, the second terminal 132 is connected to a ground connection 160 of the on-shore power supply 170, which may also be called on-shore power protective earth, via the marine vessel power connector 140 and the on-shore power connector 150. Note that a neutral (N) line, which is not shown in Figure 2, may also be present.

As is further shown in Figure 2, the on-shore power supply provides three-phase power to the marine vessel. The connection between the marine power connector 140 and the on-shore power connector 150 comprises a three-phase connection 102 and a ground connection 103, which may be arranged in a single cable.

The marine protection circuit 130 is configured to engage when a voltage across the first and the second terminals 131, 132 is above a selectively set threshold value. In particular, the marine protection circuit 130 is configured to present low resistance between the first and the second terminals 131, 132 when engaged. The marine protection circuit 130 is further configured to present high resistance between the first and the second terminals 131, 132 when unengaged.

The marine protection circuit 130 is configured to toggle between an unengaged mode and an engaged mode at least once. Preferably, the marine protection circuit 130 can toggle back and forth between these two modes any number of times. The toggle between the two modes may be performed by an electrical switch reacting upon the voltage across the first and the second terminals. The marine protection circuit 130 is, in other words, configured to switch from presenting a high-resistance path between the first and the second terminals and presenting a low-resistance path between the first and the second terminals. The low-resistance path is preferably a short circuit between the first and the second terminals 131, 132. In practice, a short circuit may mean a resistance less than 1 Ohm. Similarly, the high-resistance path is preferably an open circuit between the first and the second terminals 131, 132. In practice, an open circuit may mean a resistance larger than 1 Megaohm.

The marine protection circuit 130 is configured to present the high-resistance path when the voltage across the first and the second terminals is below the selectively set threshold value. The marine protection circuit 130 is further configured to present the low-resistance path upon the voltage across the first and the second terminals surpassing the selectively set threshold value. This selectively set threshold value may be a predetermined threshold value such as 20 Volt. The threshold value may thus selectively be set to a specific voltage which is not possible for a galvanic isolator.

In normal operation, the voltage across the first and the second terminals is zero or at least a relatively low nominal value. With a selectively set threshold selected as a higher value than said nominal value, the marine protection circuit 130 will present a high-resistance path between the first and the second terminals during normal operation. Consequently, the marine protection circuit 130 provides protection from corrosion currents. The high resistance preferably isolates the first and the second terminals from each other, or at least significantly reduce any current flowing between these terminals. The selectively set threshold value may e.g. be selected as a value larger than 20 Volt.

If there is an accidental connection/short circuit from one of the phases provided from the on-shore power supply to the marine vessel ground, the marine protection circuit 130 will engage the low-resistance path between the first and the second terminals. This low-resistance path between the first and the second terminals enables an electrical safety device to quickly break an electrical circuit comprising the path with the leakage current to ground. Such electrical safety device may be a residual-current device (RCD) or a fuse. Consequently, the disclosed marine protection circuit 130 maintains electrical safety.

There may be a buildup of static electricity on the marine vessel ground if it is isolated from the ground connection of the on-shore power supply. For example, if the hull of the marine vessel constitutes the marine vessel ground, the hull may be charged in a way similar to how a capacitor is charged. The buildup of electric charge may present a danger to equipment and people since it may be discharged in an uncontrolled manner. With a selectively set threshold selected as a maximum tolerable value for such static buildup, the marine protection circuit 130 will discharge the buildup when it surpasses the selectively set threshold such that the maximum tolerable value is never surpassed. The selectively set threshold value may e.g. be selected as maximally 60 Volts. Consequently, the selectively set threshold value may be selected as a value between 20 and 60 Volt.

The marine protection circuit 130 may be provided with a switch (not shown) for engaging the marine protection circuit 130 manually. Said switch may connect the first and the second terminals 131, 132, i.e., provide a short circuit or low-resistance path between the connected the first and the second terminals 131, 132, upon activation of a control signal. In this way, the marine protection circuit 130 may be both automatically engaged (via the selectively set threshold voltage being surpassed) and manually engaged.

In the example of Figure 2, the marine protection circuit 130 is arranged between the marine vessel load 110 and the marine vessel power connector 140. In general, however, the marine protection circuit 130 may be arranged anywhere along the ground connection from the marine vessel 100 and the on-shore power supply 170. Therefore, there is also disclosed herein an on-shore power supply 170 for providing power to a marine vessel 100 or a waterborne object, where the on-shore power supply comprises the marine protection circuit 130 according to the discussions above.

There is also disclosed herein a marine vessel 100 or waterborne object comprising the marine protection circuit 130 according to the discussions above. There is further disclosed herein a marine power connector 140 for a marine vessel 100 or a waterborne object, where the marine power connector 140 comprises the marine protection circuit 130 according to the discussions above. The marine power connector may be a plug or a socket suitable for connecting a marine vessel or waterborne object to an on-shore power supply. The marine power connector may be configured to be installed on a marine vessel or a waterborne object. There is also disclosed herein an on-shore power connector 150 for an on-shore power supply 170, where the on-shore power connector 150 comprises the marine protection circuit 130 according to the discussions above. The on-shore power connector may be a plug or a socket suitable for connecting a marine vessel or waterborne object to an on-shore power supply. The on-shore power connector may be configured to be installed on an on-shore power supply.

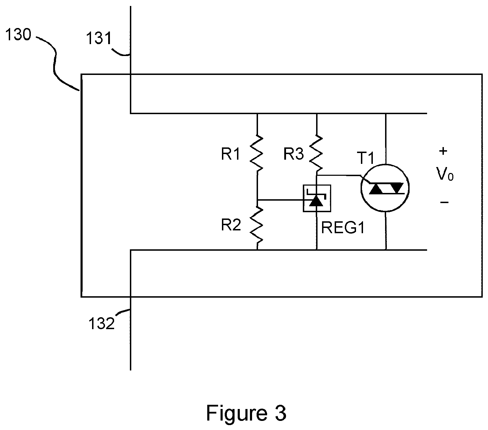

Figure 3 shows an example marine protection circuit 130. In particular, the example marine protection circuit 130 comprises a crowbar circuit connected between the first and the second terminals 131, 132. The voltage across the first and the second terminals is denoted V₀. This example crowbar circuit comprises a so-called TRIAC T1. A TRIAC is a type of three-terminal thyristor that allows bidirectional current flow when triggered. In Figure 3, a voltage regulator REG controls the gate of the TRIAC (the gate is the leftmost terminal of T1 in the figure). Resistors R1 and R2 divide the voltage V₀ to provide a reference voltage for the voltage regulator. When the voltage across R2 is below a selectively set threshold value of the voltage regulator, the voltage regulator is in an off-state and conducts no or very little current. With proper dimensioning of R3, the TRIAC is in an off state, i.e., not conducting current, when the voltage across R2 is below the selectively set threshold. If V₀ increases, the voltage across R2 will eventually surpass the selectively set threshold. In that case, the voltage regulator will draw current, and the TRIAC will be latched on, i.e., start to conduct current.

The crowbar circuit of Figure 3 thus presents a high resistance between the first and the second terminals 131, 132 when the TRIAC is unengaged. The high-resistance value is dominated by R1-R3, but is also affected somewhat by non-ideal resistive components of the voltage regulator and the TRIAC. The crowbar circuit furthermore presents low resistance between the first and the second terminals 131, 132 when the TRIAC is engaged. Ideally, the low-resistance value corresponds to a short circuit. In practice, however, non-ideal resistive components of the TRIAC are likely present.

Other types of crowbar circuits than the example in Figure 3 also exist, but are not discussed further herein.

The crowbar circuit may be an active crowbar circuit. An active crowbar can remove the short circuit, i.e., be unengaged after it has been engaged. This allows the protection circuit to resume normal operation after it has been triggered.

The marine protection circuit 130 may comprise means to be "fail safe", which is typically desired. Being fail safe means is that if the marine protection circuit 130 is compromised by, e.g., a surge or other fault, the circuit will engage (i.e., present the low resistance between the first and the second terminals).

### REFERENCE SIGNS

- 100:: Marine vessel
- 101:: Battery
- 102:: 3-phase power connection
- 103:: Ground connection
- 110:: Marine vessel load
- 120:: Ground connection of a marine vessel
- 130:: Marine protection circuit
- 131:: First terminal
- 132:: Second terminal
- 140:: Marine power connector
- 150:: On-shore power connector
- 160:: Ground connection of an on-shore power supply
- 170:: On-shore power supply

## Claims

1. A marine protection circuit (130) comprising a first terminal (131) connectable to a ground connection (120) of a marine vessel (100) or a waterborne object and a second terminal (132) connectable to a ground connection (160) of an on-shore power supply (170), wherein the marine protection circuit (130) is configured to engage when a voltage across the first and the second terminals (131, 132) is above a selectively set threshold value, wherein the marine protection circuit (130) is configured to present low resistance between the first and the second terminals (131, 132) when engaged, and wherein the marine protection circuit (130) is configured to present high resistance between the first and the second terminals (131, 132) when unengaged.

2. The marine protection circuit (130) according to claim 1, wherein the marine protection circuit (130) is configured to present a short circuit between the first and the second terminals (131, 132) when engaged.

3. The marine protection circuit (130) according to any previous claim, wherein the marine protection circuit (130) is configured to present an open circuit between the first and the second terminals (131, 132) when unengaged.

4. The marine protection circuit (130) according to any previous claim, comprising a crowbar circuit connected between the first and the second terminals (131, 132).

5. The marine protection circuit (130) according to claim 4, wherein the crowbar circuit is an active crowbar circuit.

6. The marine protection circuit (130) according to any previous claim, wherein the selectively set threshold value is larger than 20 Volt.

7. The marine protection circuit (130) according to any previous claim, wherein the selectively set threshold value is within 20 to 60 Volt.

8. An on-shore power supply (170) for providing power to a marine vessel (100) or a waterborne object, the on-shore power supply (170) comprising the marine protection circuit (130) according to any of claims 1-7.

9. A marine vessel (100) or waterborne object comprising the marine protection circuit (130) according to any of claims 1-7,

10. A marine power connector (140) for a marine vessel (100) or waterborne object, the marine power connector (140) comprising the marine protection circuit (130) according to any of claims 1-7, where the marine power connector (140) is arranged to connect to an on-shore power supply (170).

11. The marine power connector (140) according to claim 10, wherein the marine power connector (140) is adapted to conduct one-phase power or three-phase power.

12. An on-shore power connector (150) for an on-shore power supply (170), the on-shore power connector (150) comprising the marine protection circuit (130) according to any of claims 1-7, where the on-shore power connector (150) is arranged to connect to a marine vessel (100) or a waterborne object.

13. The on-shore power connector (150) according to claim 12, wherein the on-shore power connector (150) is adapted to conduct one-phase power or three-phase power.
